# EUROPEAN PATENT SPECIFICATION

(11) **EP 3 112 023 B1**
(45) Date of publication and mention of the grant of the patent: **02.10.2019**
(21) Application number: 16150231.5
(22) Date of filing: 05.01.2016
(51) Int. Cl.: B01J 20/28, B01J 20/04, B01J 20/16, C02F 1/28, B01J 20/02

(54) **ADSORPTION MATERIAL AND METHOD OF FABRICATING THE SAME**
ADSORPTIONSMATERIAL UND VERFAHREN ZUR HERSTELLUNG DAVON
MATÉRIAU D'ADSORPTION ET SON PROCÉDÉ DE FABRICATION

(30) Priority: 29.06.2015 TW 104120915
(43) Date of publication of application: 04.01.2017
(73) Proprietor: Industrial Technology Research Institute, Hsinchu (TW)
(72) Inventor: TSAI, Chia-Lin, 31040 Hsinchu (TW); TSAI, Cheng-Kuo, 31040 Hsinchu (TW); HUNG, Huan-Yi, 31040 Hsinchu (TW); LIU, Pang-Hung, 31040 Hsinchu (TW); TAI, Hsien-Hui, 31040 Hsinchu (TW)
(74) Representative: Grünecker Patent- und Rechtsanwälte PartG mbB

(56) References cited:
- WO-A1-2014/146481
- US-A- 4 824 808
- US-A1- 2014 151 303
- DUFFUS J H ET AL: "Heavy Metals-a meaningless term ?", PURE & APPLIED CHEMISTRY, PERGAMON PRESS, OXFORD, GB, vol. 74, no. 5, 1 January 2002 (2002-01-01), pages 793-807, XP002486816, ISSN: 0033-4545, DOI: 10.1351/PAC200274050793
- SING K S W ET AL: "Reporting Physisorption Data for Gas/Solid Systems with Special Reference to the Determination of Surface Area and Porosity", PURE & APPLIED CHEMISTRY, PERGAMON PRESS, OXFORD, GB, vol. 57, no. 4, 1 January 1985 (1985-01-01), pages 603-619, XP001181366, ISSN: 0033-4545

## Description

### TECHNICAL FIELD

The disclosure relates to an adsorption material and a method of fabricating the same.

### BACKGROUND

With the growing demands of consumer electronics, the liquid crystal display (LCD) factories continuously extend the production capacity in order to meet the demands of the market. However, more and more waste glasses are produced because of the expiration of the service life of the LCD. An amount of waste LCDs in Taiwan currently has reached to ten thousand tons per year, and this amount will increase each year forecast. Because the composition of an LCD panel glass is an aluminosilicate glass (RO-Al₂O₃-SiO₂, wherein RO represents an alkali-free glass compositions such as BaO, CaO, MgO and SrO), this material has many properties including unitary composition, low chemical reactivity, high temperature resistant, high glass transition temperature, high melting point, high hardness and so on. Therefore, the waste LCD panel glasses could not be processed and reused by using general manufacturing facilities of soda-lime glass. Most of waste LCD panel glasses are treated by burying methods, but the recycling related to the waste LCD panel glasses has become an important issue for environmental protection.

With the extension of production capacity, there is a large number of industrial wastewater produced from various industrial processes, such as an arsenic (As) commonly used in the semi-conductive fabrication, or well-known heavy metals (zinc, lead, copper, chromium, nickel, cadmium, etc.) in wastewater produced from the electroplating factory. These industrial wastewaters are mostly treated by a high cost conventional chemical precipitation processing. This could cause secondary contamination when the chemical toxic sludge is not well treated. Another well-known method of wastewater treatment is by utilizing zeolites, but the zeolites would be disintegrated or lost the adsorption capacity in strong acids and could not be applied for wastewater treatment in strong acids.

Based on the above, resolving a huge number of waste LCD panel glasses to reduce an environmental impact and providing a more effective recycling method of waste LCD panel glasses to create a substantial value are needed. Also, the development of a more convenient and effective method of treating heavy metals contamination in water is urgent.

WO 2014/146481 discloses an impregnated and activated ion exchange material obtained by a process comprising: impregnating an ion exchange precursor material by reacting said ion exchange precursor material with an impregnator solution, thereby increasing the surface area and the hydrophilicity of the material; and activating the impregnated ion exchange precursor material to increase the porosity thereof, wherein the ion exchange precursor material comprises at least one of nonmetallic printed (NMP) circuit board, amorphous aluminosilicate, or mixtures thereof.

### SUMMARY

The present invention relates to an adsorption material. The adsorption material comprises a plurality of porous silicate particles having a glass-phase structure and including silicon oxide, aluminum oxide, barium oxide, strontium oxide and boron oxide, wherein an average pore size of the plurality of porous silicate particles is in a range of from 3 nm to 50 nm, and a zeta potential of the plurality of porous silicate particles is negative at a pH value of from 1 to 5, and the adsorption material is obtainable by a method comprising: mixing a silicate powder and at least one metal compound, wherein the silicate powder comprises silicon oxide, aluminum oxide, barium oxide, strontium oxide and boron oxide, and the at least one metal compound is selected from the group consisting of potassium carbonate, sodium carbonate, calcium carbonate and magnesium carbonate; reacting the silicate powder with the metal compound to form silicate molten at a temperature of from 800°C to 1500°C, wherein the silicate molten is cooled to room temperature to form a plurality of porous silicate particles having a glass-phase structure and wherein the average pore size of the plurality of porous silicate particles is in the range of from 3 nm to 50 nm, the zeta potential of the plurality of porous silicate particles is negative at a pH value of from 1 to 5, and the weight ratio of the silicate powder relative to the metal compound is in the range of from 1:1 to 1:20, wherein the average pore size of the plurality of porous silicate particles is measured by the BJH method, and the zeta potential of the plurality of porous silicate particles is measured by the electrophoretic light scattering method using a zeta potential analyzer.

The present invention is also directed to a method of fabricating an adsorption material. The method comprises: providing a silicate powder and at least one metal compound, wherein the silicate powder includes silicon oxide, aluminum oxide, barium oxide, strontium oxide and boron oxide; and forming a plurality of porous silicate particles having a glass-phase structure by reacting the silicate powder with the metal compound at a temperature of from 800°C to 1500°C, wherein an average pore size of the plurality of porous silicate particles is in a range of from 3 nm to 50 nm, a zeta potential of the plurality of porous silicate particles is negative at a pH value of from 1 to 5, and a weight ratio of the silicate powder relative to the metal compound is in a range of from 1: 1 to 1:20. The at least one metal compound is selected from the group consisting of potassium carbonate, sodium carbonate, calcium carbonate and magnesium carbonate.

### BRIEF DESCRIPTION OF THE DRAWINGS

FIG. 1A is a scanning electron microscope (SEM) image of a waste LCD panel shattered glass powder according to the present disclosure;
FIG. 1B is an SEM image of an adsorption material according to an exemplary embodiment of the present disclosure;
FIG. 2 is a transmission electron microscope (TEM) image of an adsorption material according to the present disclosure;
FIG. 3A is an X-ray diffraction (XRD) pattern of a waste LCD panel shattered glass powder according to the present disclosure;
FIG. 3B is an XRD pattern of an adsorption material according to an exemplary embodiment of the present disclosure;
FIG. 4A is a schematic diagram showing the surface structure of the porous silicate particles in an adsorption state according to the present disclosure;
FIG. 4B is a schematic diagram showing the surface structure of the porous silicate particles in a desorption state according to the present disclosure;
FIG. 4C is a schematic diagram showing the surface structure of the porous silicate particles in a regeneration state according to the present disclosure;
FIG. 5 is a diagram showing the relation between the pH value and the zeta potential of the adsorption material according to an exemplary embodiment of the present disclosure; and
FIGs. 6A to 6F are diagrams respectively showing the adsorption relation between the adsorption material and various concentrations of copper (Cu), nickel (Ni), cadmium (Cd), chromium (Cr), zinc (Zn) and lead (Pb).

### DESCRIPTION OF THE EMBODIMENTS

Below, the exemplary embodiments will be described in detail, so as to be easily realized by a person having ordinary knowledge in the art. The inventive concept may be embodied in various forms, without being limited to the exemplary embodiments set forth herein. Descriptions of well-known parts are omitted for clarity, and like reference numerals refer to like elements throughout.

As used in the specification and claims, the singular forms "a", "an" and "the" include plural references unless the context clearly dictates otherwise.

In the present disclosure, the term "glass-phase" means an amorphous (i.e. non-crystalline) solid state. In addition, the silicate structure having a glass-phase structure is quite complex, the composition thereof represents in the form of various metal oxides rather than a salt form. The term "heavy metal" represents a transition metal having biological toxicity and a metalloid such as selenium, tellurium, arsenic, and so on.

In the present disclosure, according to the physical and chemical properties of LCD panel glasses, the composition and chemical structure of LCD panel glasses are reset by using a modifier. The LCD panel glass may remain stable in an acidic or basic condition, and increase the chemical activity and physical adsorption by changing the surface property, thereby making a reusable adsorption material having a high adsorption capacity by using waste LCD panel glasses as raw materials.

In an embodiment, a method of fabricating the adsorption material includes the following steps. Firstly, a silicate powder made of waste LCD panel glasses and a metal compound are provided, and the silicate powder includes silicon oxide, aluminum oxide, barium oxide, strontium oxide and boron oxide. Subsequently, the silicate powder is reacted with the metal compound at a temperature of from 800°C to 1500°C, and this forms a plurality of porous silicate particles having a pore size of 1 nm to 100 nm and an average pore size of from 3 nm to 50 nm.

In an embodiment, the silicate powder may be prepared by shattering the waste LCD panel glasses, and the size of the silicate powder may be, but not limited to, several micrometers to several millimeters. The composition of the silicate powder includes silicon oxide, aluminum oxide, barium oxide, strontium oxide and boron oxide, wherein the amount of the boron oxide is greater than 5%, based on a total weight of the silicate powder.

In another embodiment, the silicate powder may be prepared by using both waste LCD panel glasses and soda-lime glasses. Therefore, the composition of the silicate powder further includes sodium oxide, magnesium oxide and calcium oxide.

In the present disclosure, the silicate powder is mixed, melted and reacted with a metal compound having a higher activity which is selected from the group consisting of potassium carbonate, sodium carbonate, calcium carbonate and magnesium carbonate at a temperature of from 800°C to 1500°C. The metal ions of a group IA or IIA may remove the metal ions of group IIIA (such as boron) existed in the chemical structure of the silicate powder. This modifies an original bone structure of the silicate to create the active sites of the metal ions having an adsorption capacity and a high reactivity, wherein the metal ions having the high reactivity may proceed an interchange reaction with the heavy metals in an acid condition. Also, a large number of nanoscale pores are formed in the silicate structure, and the nanoscale pores are more effective in adsorbing the heavy metals than the microscale pores.

The metal compound having a weight not less than that of the silicate powder is mixed and melted with the silicate powder. The weight ratio of the silicate powder relative to the metal compound is in a range of from 1:1 to 1:20, such as from 1:1 to 1:10.

The temperature of the silicate powder reacting with the metal compound may be in a range of from 800°C to 1500°C, such as from 900°C to 1300°C. The reaction time is not greater than 1 hour, such as from 5 minutes to 30 minutes. After the reaction is completed, the silicate molten is cooled to a room temperature by natural cooling or rapid cooling, and this forms a plurality of porous silicate particles having a glass-phase structure.

Because of existing an excess of the metal compounds, the remnant metal compound and impurities may be dissolved with an acidic solution (such as from 0.1 M to 1 M of nitric acid, hydrochloric acid, citric acid or mixture thereof) after cooling. Subsequently, the solid is separated by using a solid-liquid separation process, and dried at a temperature greater than 110°C, and the porous silicate particles having a glass-phase structure are obtained.

In the present disclosure, an adsorption material comprises a plurality of porous silicate particles having a glass-phase structure. The composition of the plurality of porous silicate particles includes silicon oxide, aluminum oxide, barium oxide, strontium oxide and boron oxide, wherein an amount of the boron oxide is less than 5% based on the total weight of the plurality of porous silicate particles.

A size of the porous silicate particles may be, but not limited to, several micrometers to several millimeters. A pore size of the porous silicate particles may be in a range of from 1 nm to 100 nm. The average pore size of the porous silicate particles is in a range of from 3 nm to 50 nm, such as from 8 nm to 25 nm. A specific surface area (measured by a Brunauer-Emmett-Teller (BET) method) of the porous silicate particles may be in a range of from 65 m²/g to 500 m²/g.

The adsorption material further includes an active metal, and the active metal is adsorbed at the active sites of the specific surface of the porous silicate particles. The active metal includes at least one of sodium (Na), potassium (K), calcium (Ca) and magnesium (Mg), wherein the amount of the active metal may be in a range of from 3% to 21% based on a total weight of the adsorption material (i.e. the total weight of the porous silicate particles and the active metal).

In the present disclosure, the porous silicate particles of the adsorption material simultaneously have a large number of asymmetric charges, ion exchange sites (i.e. active sites) and pores forming a high specific surface area, and thus may chemically and physically adsorb the heavy metals in the wastewater.

The adsorption material according to the embodiments of the present disclosure may be applied to adsorb the heavy metals in the wastewater. The adsorption material may be in an adsorption state for absorbing heavy metals, or in a desorption state for removing the heavy metals, or in a regeneration state regenerating at least one active metal having a high reactivity. The adsorption material may further include a heavy metal adsorbed in the porous silicate particles in the adsorption state, and the heavy metal includes at least one of a transition metal and arsenic (As). The weight of the heavy metal can be greater than 10 mg per gram of the porous silicate particles (i.e. each gram of the porous silicate particles may adsorb the heavy metal having a weight greater than 10 mg). In other words, an adsorption capacity of the porous silicate particles to adsorb a heavy metal is greater than 10 mg per gram.

In the present disclosure, a method of wastewater treatment comprises the following steps. The wastewater having at least one heavy metal is provided, and a pH value of the wastewater is not greater than 5. Subsequently, a plurality of porous silicate particles having a glass-phase structure adsorb the at least one heavy metal in the wastewater, and the porous silicate particles include silicon oxide, aluminum oxide, barium oxide, strontium oxide and boron oxide. A pore size of the porous silicate particles is in a range of from 1 nm to 100 nm, and an average pore size of the porous silicate particles is in a range of from 3 nm to 50 nm.

In the present disclosure, the porous silicate particles may be reused through being desorbed and regenerated. Therefore, after the porous silicate particles adsorb the at least one heavy metal, the method of wastewater treatment further includes the following steps. Firstly, the at least one heavy metal adsorbed in the porous silicate particles are desorbed by an acid solution. The porous silicate particles desorbing the at least one heavy metals are further regenerated by an alkaline solution, and the porous silicate particles in a regeneration state may proceed the adsorption treatment again, that is, the porous silicate particles may adsorb one or more heavy metals in wastewater again.

In the present disclosure, the porous silicate particles adsorbing the at least one heavy metal are desorbed by a 4 wt% to 5 wt% (weight %) of an nitric acid solution, and reacted at a room temperature for 5 minutes to 20 minutes, and this may interchange the at least one heavy metal adsorbed in the porous silicate particles with hydrogen ions (H⁺) in the acid solution. The porous silicate particles desorbing the at least one heavy metal are regenerated by a sodium hydroxide (NaOH) or a potassium hydroxide (KOH) solution at a pH value of from 6 to 10.5, and the hydrogen ions at the active sites of the porous silicate particles are interchanged with the sodium or potassium ions in the alkaline solution, and this may regenerate an active metal having a high reactivity at the active sites of the porous silicate particles.

### EXAMPLES 1-11 Preparation of the Adsorption Materials

After the waste LCD panel shattered glass powders were dissolved in a hydrogen fluoride (HF) solution, the composition and a weight ratio thereof were analyzed by an inductively coupled plasma atomic emission spectrometry (ICP-AES) analysis. The results are shown in Table 1.

**Table 1**

| Composition | SiO₂ | Al₂O₃ | B₂O₃ | CaO | MgO | SrO | Polyvalent Element |
|---|---|---|---|---|---|---|---|
| Weight % | 58.9 | 17.8 | 8.5 | 3.05 | 3.2 | 8.38 | 0.17 |

The silicate powders were prepared from waste LCD panel shattered glass. The silicate powders and the metal compound were mixed by employing various weight ratios, and reacted at various temperatures to form the porous silicate particles, and the adsorption materials according to the present disclosure was obtained. The compositions and the reaction temperatures of Examples 1-11 are shown in Table 2.

**Table 2**

| Adsorption Material | Waste LCD Panel Shattered glass powder (g) | Group IA Compound | Group IIA Compound | Reaction Temperature (°C) |
|---|---|---|---|---|
| Example 1 | 200 | 200 g Na₂CO₃ | 20 g CaCO₃ | 1500 |
| Example 2 | 200 | 400 g Na₂CO₃ | 20 g CaCO₃ | 1500 |
| Example 3 | 200 | 600 g Na₂CO₃ | 0 | 1300 |
| Example 4 | 200 | 800 g Na₂CO₃ | 0 | 1300 |
| Example 5 | 200 | 500 g Na₂CO₃ and 500 g K₂CO₃ | 0 | 1300 |
| Example 6 | 150 | 1200 g K₂CO₃ | 0 | 900 |
| Example 7 | 100 | 600 g Na₂CO₃ and 400 g K₂CO₃ | 0 | 900 |
| Example 8 | 100 | 1500 g Na₂CO₃ and 500 g K₂CO₃ | 0 | 800 |
| Example 9 | 200 | 200 g Na₂CO₃ | 10 g CaCO₃ | 1500 |
| Example 10 | 200 | 400 g Na₂CO₃ | 10 g CaCO₃ | 1500 |
| Example 11 | 200 | 600 g Na₂CO₃ | 10 g CaCO₃ | 1300 |

The waste LCD panel shattered glass powder and adsorption materials in Examples were analyzed by scanning electron microscopy (SEM), transmission electron microscopy (TEM), and X-ray diffraction (XRD), respectively.

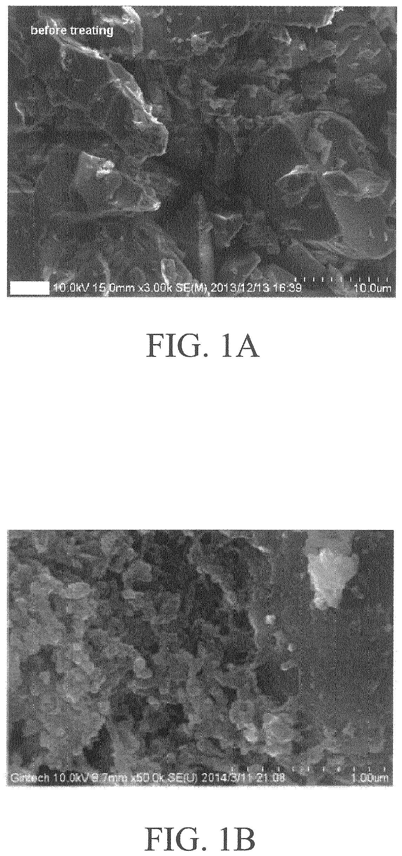

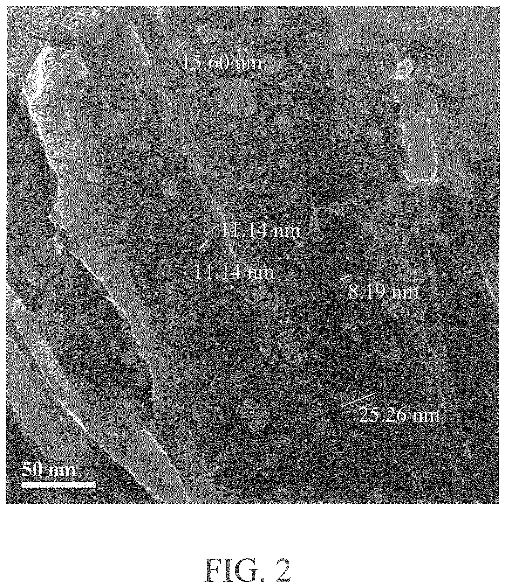

FIG. 1A is an SEM image of the waste LCD panel shattered glass powder according to the present disclosure; and FIG. 1B is an SEM image of an adsorption material according to an embodiment of the present disclosure. FIG. 2 is a TEM image of an adsorption material according to an embodiment of the present disclosure.

As shown in FIG. 1A, the waste LCD panel shattered glass powder has a non-porous and smooth surface. As shown in FIG. 1B, the adsorption material has a complex surface having a large number of pores. As shown in FIG. 2, the pore sizes of the adsorption material are in nanoscale.

Using a surface area analyzer, specific surface areas of the adsorption materials were measured by the Brunauer-Emmett-Teller (BET) method with the portion of adsorption isotherm between relative pressures of 0.058 and 0.202. The pore distributions of the adsorption materials obtained using the nitrogen desorption branch were measured by the Barrett-Joyner-Halenda (BJH) method. The specific surface areas (referred to BET specific surface areas), the average pore sizes (referred to BJH desorption average pore diameters (4V/A)) and the ratios of pore volumes of pore size from 3 nm to 50 nm (the ratio of the pore volume was calculated using the desorption isotherm by the BJH method) of the adsorption materials in Examples are shown in Table 3 below.

**Table 3**

| | Specific Surface Area (m²/g) | Average Pore Size (nm) | Ratios of Pore Volume of Pore Size from 3 nm to 50 nm (%) |
|---|---|---|---|
| Waste LCD Panel Shattered Glass Powder | 0.4 | None | None |
| Example 1 | 27.1 | 22.6 | 60.1 |
| Example 3 | 159.2 | 13.62 | 78.5 |
| Example 5 | 163.7 | 8.99 | 77.5 |
| Example 6 | 65.2 | 19.41 | 61.0 |
| Example 7 | 93.6 | 13.53 | 75.9 |
| Example 8 | 118.9 | 13.21 | 73.2 |

As shown in Table 3, the waste LCD panel shattered glass powder is nonporous, and the specific surface area thereof is merely 0.4 m²/g. By contrast, each of the adsorption materials according to the embodiments of the present disclosure has nanoscale pores, and at least 60% of a total pore volume is formed with a pore size of from 3 nm to 50 nm. Further, compared to the waste LCD panel shattered glass powder, the specific surface areas of the adsorption materials are 65.2 m²/g to 163.7 m²/g, which substantially increase about 160 times to 410 times.

After the adsorption material in Example 3 was dissolved in the HF solution, the composition and the weight ratio thereof were analyzed by the ICP-AES analysis. The results are shown in Table 4.

**Table 4**

| Composition | Al₂O₃ | B₂O₃ | BaO | CaO | MgO | Na₂O | SrO | SiO₂ |
|---|---|---|---|---|---|---|---|---|
| Weight % | 12.36 | 1.14 | 0.21 | 3.78 | 2.55 | 26.75 | 2.95 | 44.12 |

As shown in Table 4, the composition and the weight ratio of the adsorption material in Example 3 is different from those of the silicate powders. As may be seen from Table 4, the weight ratio of boron oxide in the porous silicate particles are apparently less than that in the silicate powders shown in Table 1. The difference represents the boron element in the silicate powders is partially removed, which results in the formation of nano-sized pores.

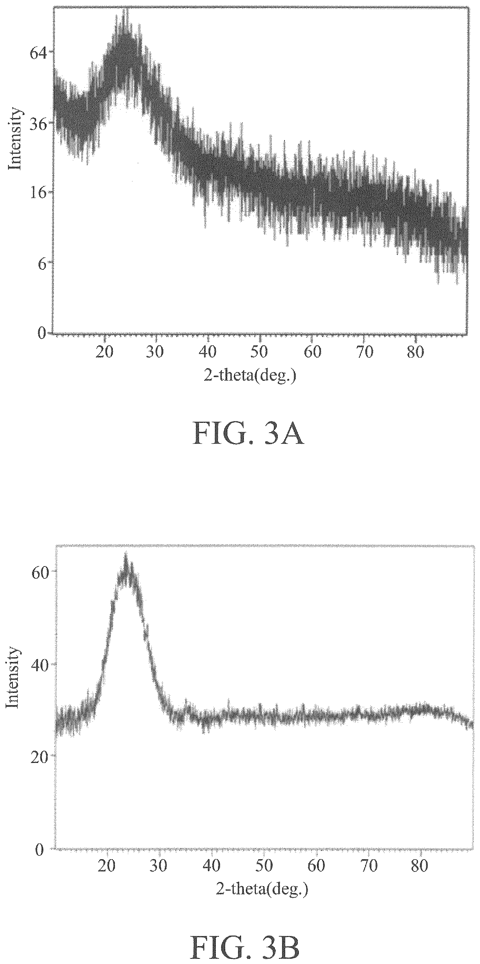

FIG. 3A is an XRD pattern of the waste LCD panel shattered glass powder according to the present disclosure; and FIG. 3B is an XRD pattern of an adsorption material according to an embodiment of the present disclosure.

As shown in FIG. 3A, pattern of the waste LCD panel shattered glass powder shows an amorphous bump around 25° representing a none-crystalline structure. Compared FIG. 3A with FIG. 3B, the adsorption material according to the embodiment of the present disclosure has a similar pattern around the same 2θ position, thus meaning that the adsorption material still retains the glass-phase chemical structure of the waste LCD panel shattered glass powder before modification. Therefore, it may be seen that the adsorption material according to the present disclosure has an acid resistance like the LCD panel glasses.

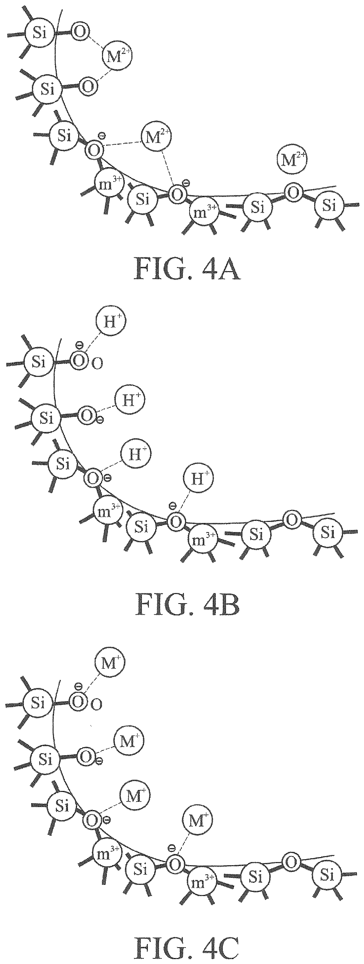

FIG. 4A is a schematic diagram showing the surface structure of the porous silicate particles in an adsorption state according to an embodiment of the present disclosure; FIG. 4B is a schematic diagram showing the surface structure of the porous silicate particles in a desorption state according to an embodiment of the present disclosure; and FIG. 4C is a schematic diagram showing the surface structure of the porous silicate particles in a regeneration state according to an embodiment of the present disclosure.

As shown in FIG. 4A to FIG. 4C, Si-O-m³⁺ represents surface structures of the porous silicate particles, Si-O⁻ represents various-charge sites, and Si-O⁻-m³⁺ represents asymmetric-charge sites. However, both the various-charge sites and the asymmetric-charge sites belong to the active sites having the reactivity. The molar ratio of silicon relative to aluminum (Si/Al ratio) in the adsorption material of a well-known silicate is usually less than 2, and the silicate structure with a high Si/Al ratio may produce a large number of asymmetric-charge sites so as to adsorb the ions in the solution. In the present disclosure, the Si/Al ratio of the porous silicate particles is in a range of from 2 to 5, such as from 3 to 4, therefore, compared the adsorption material according to the present disclosure with that of well-known silicates, the adsorption material according to the present disclosure has a higher adsorption capacity.

As shown in FIG. 4A, M²⁺ represents the heavy metals adsorbed at various-charge sites of the adsorption material, such as a divalent heavy metal cation, but not limited herein. As shown in FIG. 4B, Si-O⁻-H⁺ represents the surface hydroxyl group formed by desorbing the heavy metals at various-charge sites with the acid solution. As shown in FIG. 4C, M⁺ represents the active metal ions, formed at various-charge sites after the adsorption material is regenerated with the alkaline solution. Therefore, the active metal ions may proceed an interchange reaction with the heavy metals in strong acids again. As shown in FIG. 4A to FIG. 4C, the surface structure of the adsorption material according to the present disclosure has a large number of asymmetric charges and a huge ion-exchange capacity.

### TEST EXAMPLE 1 Surface Charge and Cation Exchange Capacity of the Adsorption Material

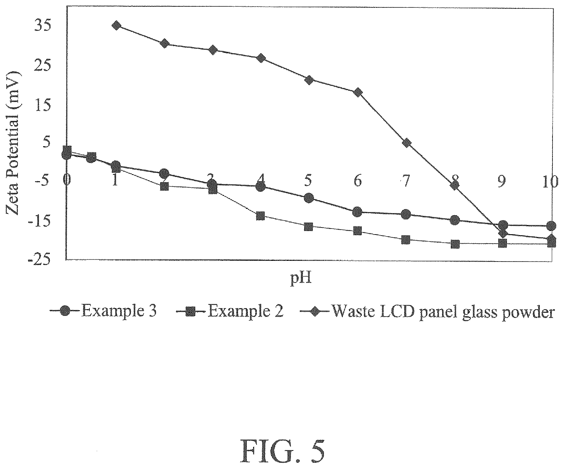

The zeta potentials of the adsorption materials in Examples 2 and 3 and the waste LCD panel shattered glass powder were measured under various pH conditions by the electrophoretic light scattering (ELS) method, using a zeta potential analyzer. And the zero point of charges (ZPCs) of the adsorption materials was determined from a relation between zeta potentials (millivolt, mV) and pH values of 0 to 10. FIG. 5 is a diagram showing the relation between the pH value and the zeta potential of the adsorption materials and the waste LCD panel shattered glass powder.

As shown in FIG. 5, the ZPC of the waste LCD panel shattered glass powder appears at pH 8.0. This result represents the positively charged surface of the waste LCD panel shattered glass powder at the pH value less than 8.0 may cause a repulsive force for heavy metal ions, therefore, the heavy metal ions in the water fail to be effectively adsorbed. However, the ZPCs of the adsorption materials in Examples 2 and 3 occur at pH 0.8, and this result represents the surfaces of the adsorption materials having a high Si/Al ratio have negative charges under strong acid condition with a pH value of from 1 to 5, and absorbs the positively charged heavy metal ions in the acid solution by utilizing the negatively charged surface. In accordance with the analysis results, the cation exchange capacities of the adsorption materials in Examples may reach to 27 meq/100 g (milliequivalent per 100 grams).

### TEST EXAMPLE 2 Maximum Adsorption Capacity of the Adsorption Material for Single Metal Ion

The adsorption capacities of the adsorption material in Example 3 were evaluated respectively for copper (Cu), nickel (Ni), lead (Pb), zinc (Zn), cadmium (Cd) and chromium (Cr). The maximum adsorption capacity (mg/g) of the adsorption material for a single heavy metal ion was calculated according to the Langmuir model for monolayer adsorption. The 100 ml of test solutions having concentrations of 5, 8, 10, 15, 20, 25, 40, 60 and 80 mg/L were prepared for each heavy metal ion, and 0.1 g of the adsorption material was added to each test solution adjusted to pH 3 to simulate the electroplating wastewater and soil washing. The adsorption test was implemented for 24 hours, and then the remaining amounts of heavy metal ions in the test solution filtered through a filtration membrane were analyzed by the ICP-AES analysis.

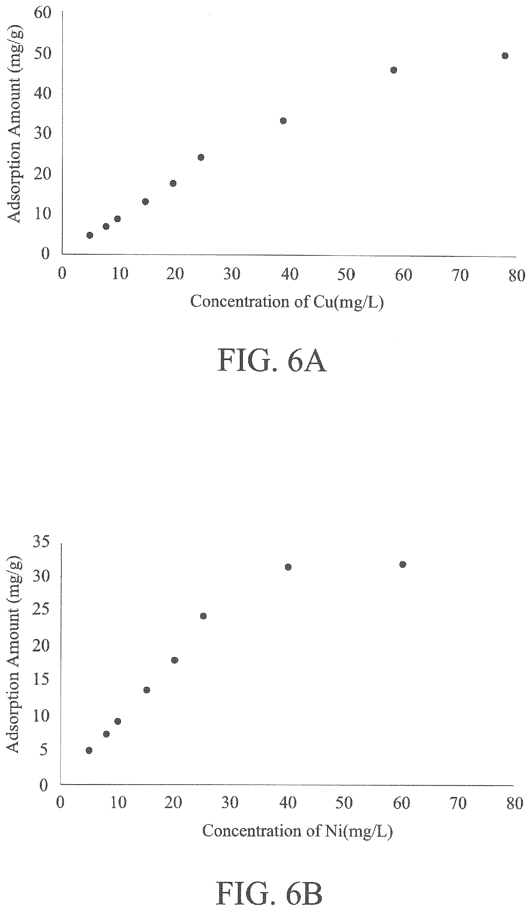

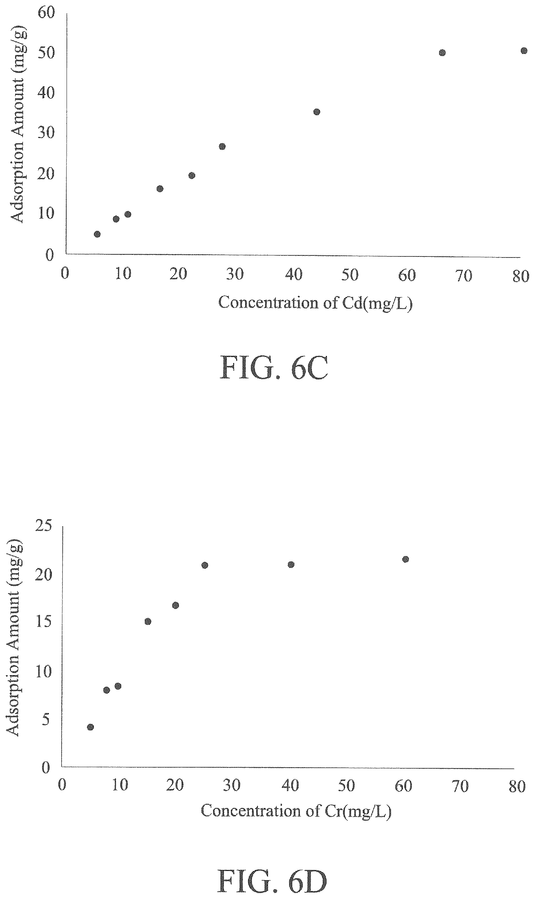

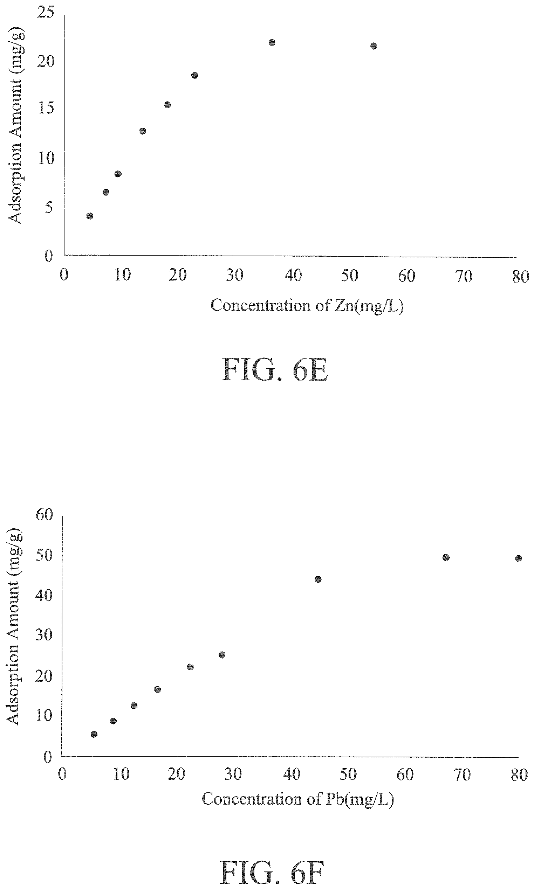

FIGs. 6A to 6F are respectively diagrams showing the Langmuir monolayer adsorption capacity of the adsorption material for various concentrations of copper (Cu), nickel (Ni), cadmium (Cd), chromium (Cr), zinc (Zn) and lead (Pb). The maximum adsorption capacity of the adsorption material for a single metal ion was calculated according to the Langmuir isotherm model, and then the results are shown in Table 5.

**Table 5**

| Heavy Metal Ion | Maximum Adsorption Capacity, qₘₐₓ (mg/g) | Equilibrium Constant, k (L/g) | Coefficient of Determination, R² |
|---|---|---|---|
| Cu | 50.0 | 3.33 | 0.9981 |
| Ni | 31.9 | 13.6 | 0.9999 |
| Cd | 52.6 | 3.80 | 0.9996 |
| Cr | 21.7 | 9.2 | 0.9999 |
| Zn | 22.1 | 2.42 | 0.9989 |
| Pb | 50.2 | 7.11 | 0.9993 |

As shown in Table 5, the adsorption material according to the present disclosure has an adsorption capacity for heavy metal ions in the strong acid solution (pH = 3), and the maximum adsorption capacity of the adsorption material for copper (Cu), nickel (Ni), cadmium (Cd), chromium (Cr), zinc (Zn) and lead (Pb) were found to be 50.0, 31.9, 52.6, 21.7, 22.1 and 50.2 mg per gram of adsorption material.

### TEST EXAMPLE 3 As-Containing Wastewater Adsorbed by the Adsorption Material

The test solution containing 110 mg/L of arsenic was prepared at the beginning, and the adsorption materials in Examples 3 and 6 were respectively added to the 200 ml of test solutions. The test solutions were shocked by an oscillator with 180 rpm for 60 minutes at a room temperature, and filtered through a 0.45-µm filter paper. The arsenic amounts of test solutions after adsorption were analyzed by the ICP-AES analysis, and then the results are shown in Table 6.

**Table 6**

| | Initial As Concentration (mg/L) | As Concentration after Adsorption (mg/L) | Removal Efficiency (%) |
|---|---|---|---|
| Example 3 | 110 | 60.5 | 45.0 |
| Example 6 | 110 | 16.7 | 84.8 |

As shown in Table 6, the removal efficiency of arsenic may be enhanced from 45% to 84.8% by using the adsorption materials made from various weight ratios of a metal compound.

### TEST EXAMPLE 4 Maximum Adsorption Capacity of the Adsorption Material for Actual Wastewater

An adsorption study of the electroplating wastewater actually obtained from a factory for multiple heavy metals was implemented by using the adsorption materials in Examples 3, 4 and 5, and which ensures the adsorption material according to the present disclosure has an adsorption capacity for the electroplating wastewater of a complicated composition. The 100 ml of the acid or alkaline electroplating wastewater containing heavy metals including Cr, Cu, Ni and Zn was prepared, and respectively adding 1 g (based on 1% weight of the electroplating wastewater) of the adsorption materials in Examples 3, 4 and 5 so as to proceed the adsorption experiment. The adsorption process was performed by the oscillator with 180 rpm for 60 minutes at 25°C, and the concentration of heavy metal ions in the electroplating wastewater after adsorption were analyzed by the ICP-AES analysis. Table 7 shows the maximum adsorption capacity and the removal efficiency of the adsorption material for multiple heavy metal ions in the electroplating wastewater.

**Table 7**

| | | Cr | Cu | Ni | Zn |
|---|---|---|---|---|---|
| Initial Concentration (mg/L) | | 33.1 | 32.1 | 38.3 | 27 |
| Example 3 | Adsorption Treated Conc. (mg/L) | 0.22 | 0.16 | 17.7 | 0.25 |
| | Adsorption Capacity (mg/g) | 3.26 | 3.19 | 2.04 | 2.65 |
| | Total Adsorption Capacity (mg/g) | 11.14 | | | |
| | Removal Efficiency (%) | 100 | 100 | 53.82 | 100 |
| Example 4 | Adsorption Treated Conc. (mg/L) | 0.18 | 0.11 | 14.9 | 0.12 |
| | Adsorption Capacity (mg/g) | 3.20 | 3.11 | 2.27 | 2.61 |
| | Total Adsorption Capacity (mg/g) | 11.19 | | | |
| | Removal Efficiency (%) | 100 | 100 | 61.07 | 100 |
| Example 5 | Adsorption Treated Conc. (mg/L) | 0.17 | 0.08 | 13.66 | 0.08 |
| | Adsorption Capacity (mg/g) | 3.29 | 3.20 | 2.47 | 2.69 |
| | Total Adsorption Capacity (mg/g) | 11.66 | | | |
| | Removal Efficiency (%) | 100 | 100 | 64.36 | 100 |

As shown in Table 7, the adsorption materials made from various compositions all have an adsorption capacity for multiple heavy metal ions in the acid or alkaline electroplating wastewater, and the maximum adsorption capacity may steadily reach up to 11 mg/g or more.

The following test examples were implemented by using the adsorption material according to the present disclosure for various wastewater treatments in accordance with discharge standards for effluent of hazardous substances in European (environmental protection agency, EPA).

### TEST EXAMPLE 5 Simulated Industrial Wastewater Treated by the Adsorption Material

A nitric acid solution containing As, Pb, Cd, Cr, Ni, Cu and Zn was prepared in the laboratory to simulate the electroplating wastewater containing multiple hazardous substances, and the initial concentrations of various hazardous substances were measured by ICP-AES analysis. The 20 g of the adsorption material in Examples 1, 2, 9 and 10 was respectively added to the 200 g of the simulated industrial wastewater (the amount of the adsorption material was 10% (w/w) based on the weight of the simulated industrial wastewater), and shocked by an oscillator with 180 rpm for 30 minutes at 25°C. The adsorption capacity and removal efficiency of the adsorption material for simulated industrial wastewater are shown in Table 8.

**Table 8**

| Hazardous Substances | | As | Cd | Cr | Cu | Ni | Pb | Zn |
|---|---|---|---|---|---|---|---|---|
| Discharge Standards (ppm) | | < 0.5 | < 0.03 | <2 | <3 | < 1 | < 1 | <5 |
| Initial Concentration (ppm) | | 109.1 | 116.8 | 114.4 | 114.8 | 115.3 | 110.9 | 110.7 |
| Example 1 | Adsorption Treated Conc. (ppm) | 28.2 | 105.5 | 56.1 | 93.3 | 71.2 | 33.1 | 97.2 |
| | Removal Efficiency (%) | 74.2 | 9.7 | 51.0 | 18.8 | 38.3 | 70.1 | 12.2 |
| Example 2 | Adsorption Treated Conc. (ppm) | 36.4 | 106.4 | 67.0 | 95.3 | 71.3 | 49.8 | 98.9 |
| | Removal Efficiency (%) | 66.7 | 8.9 | 41.4 | 17.0 | 38.1 | 55.1 | 10.6 |
| Example 9 | Adsorption Treated Conc. (ppm) | 18.9 | 105.4 | 47.2 | 91.1 | 64.8 | 36.0 | 96.4 |
| | Removal Efficiency (%) | 82.6 | 9.8 | 58.8 | 20.6 | 43.8 | 67.5 | 12.9 |
| Example 10 | Adsorption Treated Conc. (ppm) | 16.7 | 95.3 | 44.0 | 82.8 | 56.2 | 40.3 | 86.0 |
| | Removal Efficiency (%) | 84.7 | 18.4 | 61.6 | 27.9 | 51.3 | 63.7 | 22.3 |

As shown in Table 8, the adsorption materials may adsorb various heavy metal hazardous substances in the simulated industrial wastewater, and the competitive adsorption phenomenon of the adsorption materials for various hazardous substances may be observed, and the selective adsorption sequence is As> Pb> Cr> Ni> Cu> Zn> Cd.

### TEST EXAMPLE 6 Actual Cyanide-Containing Industrial Wastewater Repeatedly Treated by the Adsorption Material

An initial pH value of the cyanide-containing industrial wastewater was 2.37. Under the condition without adjusting the pH value, the 10 g of the adsorption material in Example 3 was added to the 200 g of the cyanide-containing industrial wastewater (the amount of the adsorption material was 5% (w/w) based on the weight of the cyanide-containing industrial wastewater), and repeatedly shocked plural times by an oscillator with 180 rpm for 30 minutes at 25°C. The concentrations (concentrations of metal ions) of hazardous substances in the cyanide-containing industrial wastewater after adsorption were analyzed by the ICP-AES analysis, and are shown in Table 9.

**Table 9**

| Hazardous Substances | Cr | Cu | Pb | Zn |
|---|---|---|---|---|
| Discharge Standards (ppm) | <2 | <3 | < 1 | < 5 |
| Initial Concentration (ppm) | 0.72 | 434 | 22.7 | 111 |
| Treated Conc. of First Adsorption(ppm) | 0.01 | 61.7 | 0.20 | 103 |
| Removal Efficiency of First Adsorption (%) | 98.7 | 85.8 | 99.1 | 7.2 |
| Treated Conc. of Second Adsorption (ppm) | <0.1 | 15.4 | <0.1 | 39.2 |
| Removal Efficiency of Second Adsorption (%) | - | 75.0 | - | 61.9 |
| Treated Conc. of Third Adsorption (ppm) | <0.1 | <0.1 | <0.1 | 0.11 |
| Removal Efficiency of Third Adsorption (%) | - | - | - | 99.7 |

As shown in Table 9, before a first adsorption treatment, the initial concentration of Cr has been less than discharge standards. After the first adsorption treatment, the concentration of Cr is decreased to a concentration not monitored by the analyzer; the concentration of Cu is decreased from 434 ppm to 61.7 ppm; the concentration of Pb is decreased from 22.7 ppm to 0.20 ppm (compliance with discharge standards: < 1 ppm); and the concentration of Zn is decreased from 111 ppm to 103 ppm.

After a second adsorption treatment, the concentration of Cr is still less than the discharge standards, and the results meant the addition of adsorption materials fails to result in the desorption of hazardous substances; the concentration of Cu is decreased from 61.7 ppm to 15.4 ppm; the concentration of Pb is decreased from 0.20 ppm to less than 0.1 ppm; and the concentration of Zn is decreased from 103 ppm to 39.2 ppm.

After a third adsorption treatment, the addition of adsorption materials do not result in the desorption of hazardous substances; the concentration of Cu is decreased from 15.4 ppm to less than 0.1 ppm; and the concentration of Zn is decreased from 39.2 ppm to 0.11 ppm. Finally, both of Cu and Zn may correspond with regulatory discharge standards.

The competitive adsorption phenomenon of the adsorption materials in this cyanide-containing industrial wastewater may be observed, and the selective adsorption sequence is Pb> Cr> Cu> Zn, as shown in Table 9. In the first adsorption treatment, Cu has a priority over Zn for being adsorbed by the adsorption materials, and therefore there is almost no change in the concentration of Zn. In the second adsorption treatment, the adsorption capacity of the adsorption materials for Zn significantly increases. In the third adsorption treatment, the adsorption materials mainly adsorb Zn and the concentration of Zn may correspond with regulatory discharge standards.

Furthermore, the pH value of the cyanide-containing industrial wastewater after the first adsorption treatment is 9.3; the pH value of the cyanide-containing industrial wastewater after the second adsorption treatment is 9.2; and the pH value of the cyanide-containing industrial wastewater after the third adsorption treatment is 9.1. In this test example, there is non-additional process step adjusting pH value before any adsorption treatment for the cyanide-containing industrial wastewater (the initial pH value is about 3). After several treatments, not only the concentration of hazardous substances in the cyanide-containing industrial wastewater may correspond with discharge standards for effluent, but also the pH value of the cyanide-containing industrial wastewater may correspond with the standard for neutral water (pH of from 6 to 9).

### TEST EXAMPLE 7 Actual Acid Industrial Wastewater Repeatedly Treated by the Adsorption Material

An initial pH value of the acid industrial wastewater is 3.54. Under the condition without adjusting the pH value, the 10 g of the adsorption material in Example 11 was added to the 200 g of the acid industrial wastewater (the amount of the adsorption material was 5% (w/w) based on the weight of the acid industrial wastewater), and repeatedly shocked plural times by an oscillator with 180 rpm for 30 minutes at 25°C. The concentrations (concentrations of metal ions) of hazardous substances in the acid industrial wastewater after adsorption were analyzed by the ICP-AES analysis, and are shown in Table 10.

**Table 10**

| Hazardous Substances | Cr | Cu | Pb | Zn |
|---|---|---|---|---|
| Discharge Standards (ppm) | < 2 | < 3 | < 1 | < 5 |
| Initial Concentration (ppm) | 39.4 | 35.5 | 0.19 | 30.0 |
| Adsorption Treated Conc. of First Adsorption (ppm) | <0.1 | 1.90 | 0.14 | <0.1 |
| Removal Efficiency of First Adsorption (%) | 99.8 | 94.7 | 28.0 | 99.9 |
| Treated Conc. of Second Adsorption (ppm) | <0.1 | 1.17 | <0.1 | <0.1 |
| Removal Efficiency of Second Adsorption (%) | - | 38.0 | - | - |

As shown in Table 10, before a first adsorption treatment, the initial concentration of Pb has been less than discharge standards. In the procedure of the first adsorption treatment, the addition of adsorption materials fails to desorb hazardous substances. After the first adsorption treatment, the concentration of Cr is decreased from 39.4 ppm to less than 0.1 ppm (compliance with discharge standards); the concentration of Cu is decreased from 35.5 ppm to 1.90 ppm (compliance with discharge standards); and the concentration of Zn is decreased from 30.0 ppm to less than 0.1 ppm (compliance with discharge standards). Table 10 shows the removal efficiency of various hazardous substances, hazardous substances in the acid industrial wastewater are mostly removed after the first adsorption treatment, and the acid industrial wastewater after the first adsorption treatment may correspond with discharge standards for effluent. Moreover, the pH value of the acid industrial wastewater after the first adsorption treatment is 6.1; the pH value of the acid industrial wastewater after the second adsorption treatment is 6.7; and the acid industrial wastewater after treatment may also correspond with the standard for neutral water (pH of from 6 to 9).

### TEST EXAMPLE 8 Reliability Test for the Adsorption Material

The 3 g of saturated adsorption material adsorbing the heavy metals in the acid industrial wastewater was respectively taken and implemented by the Desorption-Regeneration-Adsorption process five times. The adsorption capacity and the desorption capacity were measured every time, the adsorption capacity retention rate of the adsorption material was calculated based on the first adsorption capacity, and this adsorption capacity retention rate determined the reliability of the adsorption material.

The desorption of adsorption material was performed in an acid condition, and the desorption agent may be selected from inorganic acids including citric acid, sulfuric acid, nitric acid, hydrochloric acid and so on. In this test example, nitric acid was prepared as a desorption agent, and the weight of the desorbed heavy metals per gram of the adsorption material was calculated to measure the desorption capacity of adsorption material. The desorption conditions (R1, R2 and R3) are shown in Table 11.

**Table 11**

| Desorption Conditions | Concentration of Nitric Acid (weight %) | Time (mins) |
|---|---|---|
| R1 | 4 | 5 |
| R2 | 4 | 20 |
| R3 | 5 | 20 |

The adsorption material after adsorption was added to a regeneration tank containing water (the weight ratio of the adsorption material after adsorption relative to the water was 1:1), and the 1 M NaOH solution was added to the regeneration tank until the pH value of the solution in the regeneration tank reached to pH 9. Then, the regeneration of the adsorption material was done.

The adsorption material after regeneration was implemented by the Adsorption-Desorption process again. The adsorption capacity and the desorption capacity of the adsorption material after each regeneration were measured, and the adsorption capacity retention rate of the adsorption material for heavy metals after each adsorption or regeneration was calculated based on the first adsorption capacity. Accordingly, the reliability of the adsorption material for recycling was realized. The results for the reliability test are shown in Table 12.

**Table 12**

| Reliability Test | | Desorption Condition R1 | Desorption Condition R2 | Desorption Condition R3 |
|---|---|---|---|---|
| First Time | Adsorption Capacity (mg/g) | 7.5 | 7.5 | 7.5 |
| | Desorption Capacity (mg/g) | 3.0 | 5.4 | 3.0 |
| | Desorption Efficiency (%) | 34.9 | 62.8 | 35.3 |
| Second Time | Adsorption Capacity (mg/g) | 6.1 | 6.5 | 6.4 |
| | Desorption Capacity (mg/g) | 5.2 | 5.7 | 5.2 |
| | Desorption Efficiency (%) | 85.3 | 88.6 | 80.6 |
| | Adsorption Capacity Retention Rate (%) | 81.3 | 86.7 | 85.3 |
| Third Time | Adsorption Capacity (mg/g) | 6.2 | 6.4 | 6.5 |
| | Desorption Capacity (mg/g) | 3.9 | 4.5 | 4.2 |
| | Desorption Efficiency (%) | 58.4 | 64.8 | 59.2 |
| | Adsorption Capacity Retention Rate (%) | 82.7 | 85.3 | 86.7 |
| Fourth Time | Adsorption Capacity (mg/g) | 6.6 | 7.1 | 6.5 |
| | Desorption Capacity (mg/g) | 4.1 | 4.7 | 4.3 |
| | Desorption Efficiency (%) | 62.1 | 66.2 | 62.8 |
| | Adsorption Capacity Retention Rate (%) | 88.0 | 94.7 | 85.3 |
| Fifth Time | Adsorption Capacity (mg/g) | 6.7 | 6.8 | 6.5 |
| | Desorption Capacity (mg/g) | 4.3 | 4.5 | 4.2 |
| | Desorption Efficiency (%) | 64.2 | 66.1 | 60.8 |
| | Adsorption Capacity Retention Rate (%) | 89.3 | 90.7 | 86.7 |

As shown in Table 12, the adsorption material according to the present disclosure may maintain the adsorption efficiency greater than 80% after the Desorption-Regeneration-Adsorption process, and the adsorption material according to the present disclosure is indeed capable of being reused several times.

From the above example tests, it may be seen that the LCD panel glasses create the pore distributions through resetting the composition and rearranging the structure from FIG. 1B and FIG. 2. The adsorption material is based on the Langmuir isotherm model for a monolayer adsorption from Test Example 2. The adsorption material has a resistance to strong acids from FIG. 3B. The adsorption material has an adsorption capacity for As from Test Example 3. A total adsorption capacity of the adsorption material for hazardous substances may reach up to 11.66 mg/g from Test Example 4. Various industrial wastewater treated by the adsorption material may correspond with regulatory discharge standards from Test Example 5, 6 and 7. And, the adsorption material may be reused several times through desorption and regeneration from the reliability test of Test Example 8.

In this present disclosure, the composition and the chemical structure of waste LCD panel glasses are reset by using metal compounds, and the adsorption material containing porous silicate particles having a glass-phase structure may be obtained. The adsorption material containing the porous silicate particles may treat hazardous substances in the wastewater by using strong acids. Not only the treated wastewater by the strong acids may correspond with regulatory discharge standards, but also the adsorption material adsorbing hazardous substances may be reused several times through desorption and regeneration.

## Claims

1. An adsorption material, comprising:
a plurality of porous silicate particles having a glass-phase structure and comprising silicon oxide, aluminum oxide, barium oxide, strontium oxide and boron oxide, wherein an average pore size of the plurality of porous silicate particles is in a range of from 3 nm to 50 nm, and a zeta potential of the plurality of porous silicate particles is negative at a pH value of from 1 to 5,
wherein the adsorption material is obtainable by a method comprising:
mixing a silicate powder and at least one metal compound, wherein the silicate powder comprises silicon oxide, aluminum oxide, barium oxide, strontium oxide and boron oxide, and the at least one metal compound is selected from the group consisting of potassium carbonate, sodium carbonate, calcium carbonate and magnesium carbonate;
reacting the silicate powder with the metal compound to form silicate molten at a temperature of from 800°C to 1500°C, wherein the silicate molten is cooled to room temperature to form a plurality of porous silicate particles having a glass-phase structure and wherein the average pore size of the plurality of porous silicate particles is in the range of from 3 nm to 50 nm, the zeta potential of the plurality of porous silicate particles is negative at a pH value of from 1 to 5, and the weight ratio of the silicate powder relative to the metal compound is in the range of from 1:1 to 1:20,
wherein the average pore size of the plurality of porous silicate particles is measured by the BJH method, and the zeta potential of the plurality of porous silicate particles is measured by the electrophoretic light scattering method using a zeta potential analyzer.

2. The adsorption material of claim 1, wherein the specific surface area of the plurality of porous silicate particles is in the range of from 65 m²/g to 500 m²/g measured by the BET method using a surface area analyzer.

3. The adsorption material of claim 1, wherein at least 60% of the total pore volume of the plurality of porous silicate particles is formed with a pore size of from 3 nm to 50 nm, calculated using the desorption isotherm by the BJH method.

4. The adsorption material of claim 1, wherein the molar ratio of silicon relative to aluminum in the plurality of porous silicate particles is in the range of from 2 to 5.

5. The adsorption material of claim 1, wherein the amount of the active metal is in the range of from 3% to 21% based on the total weight of the adsorption material.

6. A method of fabricating an adsorption material, comprising:
mixing a silicate powder and at least one metal compound, wherein the silicate powder comprises silicon oxide, aluminum oxide, barium oxide, strontium oxide and boron oxide, and the at least one metal compound is selected from the group consisting of potassium carbonate, sodium carbonate, calcium carbonate and magnesium carbonate;
reacting the silicate powder with the metal compound to form silicate molten at a temperature of from 800°C to 1500°C, wherein the silicate molten is cooled to room temperature to form a plurality of porous silicate particles having a glass-phase structure and wherein the average pore size of the plurality of porous silicate particles is in the range of from 3 nm to 50 nm, the zeta potential of the plurality of porous silicate particles is negative at a pH value of from 1 to 5, and the weight ratio of the silicate powder relative to the metal compound is in the range of from 1:1 to 1:20,
wherein the average pore size of the plurality of porous silicate particles is measured by the BJH method, and the zeta potential of the plurality of porous silicate particles is measured by the electrophoretic light scattering method using a zeta potential analyzer.

7. The method of claim 1, wherein the amount of the boron oxide is greater than 5% based on the total weight of the silicate powder, and the amount of the boron oxide is less than 5% based on the total weight of the plurality of porous silicate particles.

8. The method of claim 1, wherein the molar ratio of silicon relative to aluminum in the plurality of porous silicate particles is in the range of from 2 to 5.

9. The method of claim 1, wherein the specific surface area of the plurality of porous silicate particles is in the range of from 65 m²/g to 500 m²/g measured by the BET method using a surface area analyzer.

## Patentansprüche

1. Adsorptionsmaterial, mit:
mehreren porösen Silicatteilchen, die eine Glasphasenstruktur aufweisen und Siliziumoxid, Aluminiumoxid, Bariumoxid, Strontiumoxid, und Boroxid aufweisen, wobei eine mittlere Porengröße der mehreren porösen Silicatteilchen im Bereich von 3 mm 50 mm liegt, und ein Zeta-Potential der mehreren porösen Silicatteichen bei einem pH-Wert von ungefähr 1 bis 5 negativ ist,
wobei das Adsorptionsmaterial durch ein Verfahren gewinnbar ist, das umfasst:
Mischen eines Silicatpulvers und mindestens einer Metallverbindung, wobei das Silicatpulver Siliziumoxid, Aluminiumoxid, Bariumoxid, Strontiumoxid und Boroxid enthält, und die mindestens eine Metallverbindung ausgewählt ist aus der Gruppe: Kaliumcarbonat, Natriumcarbonat, Kalziumcarbonat und Magnesiumcarbonat;
in Reaktion bringen des Silicatpulvers mit der Metallverbindung derart, dass Silicat gebildet wird, das bei einer Temperatur von 800 °C bis 1500 °C geschmolzen ist, wobei das geschmolzene Silicat auf Raumtemperatur gekühlt wird, so dass mehrere poröse Silicatteilchen mit einer Glasphasenstruktur gebildet werden, und wobei die mittleren Porengröße der mehreren porösen Silicatteilchen im Bereich von 3 nm bis 50 nm liegt, das Zeta-Potential der mehreren porösen Silicatteilchen bei einem pH-Wert von 1 bis 5 negativ ist, und das Gewichtsverhältnis des Silicatpulvers zu der Metallverbindung im Bereich von 1 : 1 bis 1 : 20 liegt,
wobei die mittlere Porengröße der mehreren porösen Silicatteilchen durch das BJH-Verfahren gemessen wird und das Zeta-Potential der mehreren porösen Silicatteilchen durch das elektrophoretische Lichtstreuungsverfahren unter Anwendung einer Zeta-Potential-Analyseeinheit gemessen wird.

2. Adsorptionsmaterial nach Anspruch 1, wobei die spezifische Oberfläche der mehreren porösen Silicatteilchen im Bereich von 65 m²/g bis 50 m²/g liegt, wobei die Messung durch das BET-Verfahren unter Anwendung einer Oberflächen-Analyseeinheit erfolgt.

3. Adsorptionsmaterial nach Anspruch 1, wobei, wobei mindestens 60 % des gesamten Porenvolumens der mehreren porösen Silicatteilchen mit einer Porengröße von 3 nm bis 50 nm gebildet ist, wobei die Berechnung durch unter Verwendung der Desorptionsisotherme durch das BJH-Verfahren erfolgt.

4. Adsorptionsmaterial nach Anspruch 1, wobei das molare Verhältnis von Silicium zu Aluminium in dem mehreren porösen Silicatteilchen im Bereich von 2 bis 5 liegt.

5. Adsorptionsmaterial nach Anspruch 1, wobei der Anteil des aktiven Metalls im Bereich von 3 % bis 21 % basierend auf dem Gesamtgewicht des Adsorptionsmaterials liegt.

6. Verfahren zur Herstellung eines Adsorptionsmaterials, mit:
Mischen eines Silicatpulvers und mindestens eine Metallverbindung, wobei das Silicatpulver Siliziumoxid, Aluminiumoxid, Bariumoxid, Strontiumoxid und Boroxid aufweist, und die mindestens eine Metallverbindung ausgewählt ist aus der Gruppe: Kaliumcarbonat, Natriumcarbonat, Kalziumcarbonat und Magnesiumcarbonat;
in Reaktion bringen des Silicatpulvers mit der Metallverbindung derart, dass Silicat gebildet wird, das bei einer Temperatur von 800 °C bis 1500 °C geschmolzen ist, wobei das geschmolzene Silicat auf Raumtemperatur abgekühlt wird derart, dass mehrere poröse Silicatteilchen mit einer Glasphasenstruktur gebildet werden, und wobei die mittlere Porengröße der mehreren porösen Silicatteilchen im Bereich von 3 nm bis 50 nm liegt, das Zeta-Potential der mehreren porösen Silicatteilchen bei einem pH-Wert von 1 bis 5 negativ ist, und das Gewichtsverhältnis des Silicatpulvers zu der Metallverbindung im Bereich von 1 : 1 bis 1 : 20 liegt,
wobei die mittlere Porengröße der mehreren porösen Silicatteilchen durch das BJH-Verfahren gemessen wird, und das Zeta-Potential der mehreren porösen Silicatteilchen durch das elektrophoretische Lichtstreuverfahren unter Anwendung einer Zeta-Potential-Analyseeinheit gemessen wird.

7. Verfahren nach Anspruch 1, wobei der Anteil des Boroxids auf Basis des Gesamtgewichts des Silicatpulvers größer als 5 % ist und der Anteil des Boroxids auf Basis des Gesamtgewichts der mehreren porösen Silicatteilchen kleiner als 5 % ist.

8. Verfahren nach Anspruch 1, wobei das Molverhältnis von Silicium zu Aluminium in mehreren porösen Silicatteilchen im Bereich von 2 bis 5 liegt.

9. Verfahren nach Anspruch 1, wobei die spezifische Oberfläche der mehreren porösen Silicatteilchen im Bereich von 65 m²/g bis 500 m²/g liegt, wobei die Messung unter Anwendung einer Oberflächen-Analyseeinheit durch das BET-Verfahren erfolgt.

## Revendications

1. Matériau d'adsorption, comprenant:
une pluralité de particules de silicate poreux ayant une structure en phase vitreuse et comprenant de l'oxyde de silicium, de l'oxyde d'aluminium, de l'oxyde de baryum, de l'oxyde de strontium et de l'oxyde de bore, dans lequel une taille moyenne des pores de la pluralité de particules de silicate poreux est dans une gamme de 3 nm à 50 nm et un potentiel zêta de la pluralité de particules de silicate poreux est négatif à un pH de 1 à 5,
dans lequel le matériau d'adsorption peut être obtenu par un procédé comprenant les étapes suivantes:
mélange d'une poudre de silicate et d'au moins un composé métallique, dans lequel la poudre de silicate comprend de l'oxyde de silicium, de l'oxyde d'aluminium, de l'oxyde de baryum, de l'oxyde de strontium et de l'oxyde de bore et ledit au moins un composé métallique est choisi dans le groupe constitué du carbonate de potassium, du carbonate de sodium, du carbonate de calcium et du carbonate de magnésium;
mise en réaction de la poudre de silicate avec le composé métallique pour former du silicate fondu à une température de 800°C à 1500°C, dans laquelle le silicate fondu est refroidi à la température ambiante pour former une pluralité de particules de silicate poreux ayant une structure en phase vitreuse et dans laquelle la taille moyenne des pores de la pluralité de particules de silicate poreux est comprise entre 3 nm et 50 nm, le potentiel zêta de la pluralité de particules de silicate poreux est négatif à une valeur pH comprise entre 1 et 5, et le rapport en masse entre la poudre de silicate et le composé métallique est compris dans la plage de 1:1 à 1:20,
dans lequel la taille moyenne des pores de la pluralité de particules de silicate poreux est mesurée par le procédé, et le potentiel zêta de la pluralité de particules de silicate poreux est mesuré par le procédé de diffusion de lumière électrophorétique utilisant un analyseur de potentiel zêta.

2. Matériau d'adsorption selon la revendication 1, dans lequel la surface spécifique de la pluralité de particules de silicate poreux est comprise entre 65 m²/g et 500 m²/g, mesurée par le procédé BET en utilisant un analyseur de surface.

3. Matériau d'adsorption selon la revendication 1, dans lequel au moins 60 % du volume total des pores de la pluralité de particules de silicate poreux est formé avec une taille de pores de 3 nm à 50 nm, calculée en utilisant l'isotherme de désorption selon le procédé BJH.

4. Matériau d'adsorption selon la revendication 1, dans lequel le rapport molaire du silicium par rapport à l'aluminium dans la pluralité de particules de silicate poreux est compris entre 2 et 5.

5. Matériau d'adsorption selon la revendication 1, dans lequel la quantité du métal actif se situe dans la plage de 3% à 21% par rapport au poids total du matériau d'adsorption.

6. Procédé de fabrication d'un matériau d'adsorption, comprenant les étapes suivantes:
mélange d'une poudre de silicate et d'au moins un composé métallique, dans lequel la poudre de silicate comprend de l'oxyde de silicium, de l'oxyde d'aluminium, de l'oxyde de baryum, de l'oxyde de strontium et de l'oxyde de bore et ledit au moins un composé métallique est choisi dans le groupe constitué du carbonate de potassium, du carbonate de sodium, du carbonate de calcium et du carbonate de magnésium;
mise en réaction de la poudre de silicate avec le composé métallique pour former du silicate fondu à une température de 800"C°C à 1500°C, dans laquelle le silicate fondu est refroidi à la température ambiante pour former une pluralité de particules de silicate poreux ayant une structure en phase vitreuse et dans laquelle la taille moyenne des pores de la pluralité de particules de silicate poreux est comprise entre 3 nm et 50 nm, le potentiel zêta de la pluralité de particules de silicate poreux est négatif à une valeur pH comprise entre 1 et 5, et le rapport en masse entre la poudre de silicate et le composé métallique est compris dans la plage de 1:1 à 1:20,
dans lequel la taille moyenne des pores de la pluralité de particules de silicate poreux est mesurée par le procédé BJH, et le potentiel zêta de la pluralité de particules de silicate poreux est mesuré par le procédé de diffusion de lumière électrophorétique utilisant un analyseur de potentiel zêta.

7. Procédé selon la revendication 1, dans lequel la quantité d'oxyde de bore est supérieure à 5 % par rapport au poids total de la poudre de silicate, et la quantité d'oxyde de bore est inférieure à 5 % par rapport au poids total de la pluralité de particules de silicate poreux.

8. Procédé selon la revendication 1, dans lequel le rapport molaire du silicium par rapport à l'aluminium dans la pluralité de particules de silicate poreux est compris entre 2 et 5.

9. Procédé selon la revendication 1, dans lequel la surface spécifique de la pluralité de particules de silicate poreux est comprise entre 65 m²/g et 500 m²/g, mesurée par le procédé BET en utilisant un analyseur de surface.
